Europäisches Patentamt

European Patent Office

Office européen des brevets

(11) Veröffentlichungsnummer: **0 250 366**
**A2**

(12) # EUROPÄISCHE PATENTANMELDUNG

(21) Anmeldenummer: **87810337.3**

(51) Int. Cl.⁴: **H 05 K 3/06**

(22) Anmeldetag: **12.06.87**

(30) Priorität: **18.06.86 GB 8614868**

(43) Veröffentlichungstag der Anmeldung:
**23.12.87 Patentblatt 87/52**

(84) Benannte Vertragsstaaten:
**BE CH DE ES FR GB IT LI NL SE**

(71) Anmelder: **CIBA-GEIGY AG**
**Klybeckstrasse 141**
**CH-4002 Basel (CH)**

(72) Erfinder: **Demmer, Christopher George, Dr.**
**20 Southfield Ickleton**
**Saffron Walden Essex CB10 1TE (GB)**

**Irving Edward, Dr.**
**41, Swaffham Road Burwell**
**Cambridge CB5 0AN (GB)**

(54) **Verfahren zur Herstellung metallischer Strukturen.**

(57) Gegenstand vorliegender Erfindung ist ein Verfahren zur Herstellung metallischer Strukturen auf einem Substrat mit einer in vorbestimmten Bereichen aus blankem Metall und in den übrigen Bereichen aus mit einem Abdecklack beschichteten Metall bestehenden Oberfläche, wobei man (i) das blanke Metall durch galvanische Abscheidung eines Harzes darauf schützt, (ii) unter Belassung des galvanisch abgeschiedenen Harzes in weitgehend ungehärtetem Zustand den Abdecklack aus jenen übrigen Bereichen mittels eines Lösungsmittels abzieht, welches das galvanisch abgeschiedene Harz nicht entfernt, wodurch das Metall in diesen übrigen Bereichen freigelegt wird, (iii) das in (ii) freigelegte Metall mittels eines Ätzmittels ätzt, welches das galvanisch abgeschiedene Harz nicht entfernt, und (iv) das galvanisch abgeschiedene Harz mit einem geeigneten Lösungsmittel abzieht.

EP 0 250 366 A2

**Beschreibung**

## Verfahren zur Herstellung metallischer Strukturen

Vorliegende Erfindung betrifft ein Verfahren zur Herstellung metallischer Strukturen wie gedruckter Schaltungen und dergleichen.

Zur Herstellung gedruckter Leiterplatten gibt es verschiedene Verfahren, doch sind einige der angewandten Stufen den verschiedenen Verfahren gemeinsam.

Bei einseitig bedruckten Leiterplatten werden in die aus kupferkaschiertem Laminat bestehende Platte an den gewünschten Stellen Löcher gebohrt, das Kupfer wird mittels Siebdruck oder Photoabbildungstechnik nach einem vorbestimmten Muster mit Abdecklack beschichtet, was eine Platte mit blankem Kupfer in einigen Bereichen und mit Abdecklack beschichtetem Kupfer in den übrigen Bereichen ergibt, das blanke Kupfer wird dann mit einer Zinn/Bleilegierung plattiert, der Abdecklack dann entfernt und das so freigelegte Kupfer mit einem Ätzmittel geätzt, welches die Zinn/Bleilegierung nicht entfernt, die schliesslich mit einem Entmetallisierungsmittel dafür abgezogen wird.

Die Verfahrensweise bei doppelseitigen, durchkontaktierten Leiterplatten ist ähnlich, aber mit den folgenden zusätzlichen Stufen:
Nach dem Bohren der Löcher wird die Platte einer stromlosen Kupferabscheidung unterzogen, um auf der Oberfläche der Löcher (sowie auf dem gesamten Kupfer) Kupfer abzuscheiden, und nach dem Aufbringen des Abdecklacks in einem vorbestimmten Muster wird die Platte mit Kupfer galvanisiert, um auf den blanken Kupferteilen einschliesslich der Löcheroberfläche Kupfer abzuscheiden.

Die Nachteile dieser Verfahren sind der hohe Preis des Entmetallisierungsmittels für die Zinn/Bleilegierung und die danach erforderliche Reinigung; ferner ist das Zinn/Bleientfernungsmittel (üblicherweise ein Gemisch aus Wasserstoffperoxid und Schwefelsäure) für die Platten selbst sowie das Personal und die bei der Entmetallisierung verwendeten Geräte aggressiv.

Es wurde nun gefunden, dass das nach dem Aufbringen des Abdecklacks blank gebliebene Kupfer durch galvanische Abscheidung eines galvanisch abscheidbaren Harzes geschützt werden kann, das mit einem Lösungsmittel abziehbar ist, welches von dem zur Entfernung des Abdecklacks verwendeten verschieden ist und durch das Kupferätzmittel nicht entfernt wird.

Galvanisch abscheidbare Harze sind seit langem bekannt und werden weithin zur Beschichtung von Metallgegenständen, z.B. zum Lackieren von Kraftfahrzeugkarosserien und -zubehör, Stahlträgern sowie Haushaltsgeräten wie Waschmaschinen, verwendet. Bei allen diesen Anwendungen wird das Harz galvanisch abgeschieden und dann gehärtet. In der russischen Patentschrift Nr. 293 312 wurde vorgeschlagen, ein galvanisch abscheidbares Harz zum Schutz freigelegten Kupfers bei der Herstellung einer Leiterplatte zu verwenden, aber das Harz wird wiederum nach der galvanischen Abscheidung thermisch gehärtet. Dies erschwert die Entfernung und erfordert Bedingungen, eine alkalische Lösung bei 70° bis 80°C, unter denen der Laminatträger einer Leiterplatte geschädigt werden kann.

Es wurde gefunden, dass ausreichender Schutz ohne weitgehende Härtung des galvanisch abgeschiedenen Harzes erhältlich ist.

Gegenstand vorliegender Erfindung ist demnach ein Verfahren zur Herstellung metallischer Strukturen auf einem Substrat mit einer in vorbestimmten Bereichen aus blankem Metall und in den übrigen Bereichen aus mit einem Abdecklack beschichtetem Metall bestehenden Oberfläche, welches dadurch gekennzeichnet ist, dass man (i) das blanke Metall durch galvanische Abscheidung des Harzes darauf schützt, (ii) unter Belassung des galvanisch abgeschiedenen Harzes in weitgehend ungehärtetem Zustand den Abdecklack aus jenen übrigen Bereichen mittels eines Lösungsmittels abzieht, welches das galvanisch abgeschiedene Harz nicht entfernt, wodurch das Metall in diesen übrigen Bereichen freigelegt wird, (iii) das in (ii) freigelegte Metall mittels eines Ätzmittels ätzt, welches das galvanisch abgeschiedene Harz nicht entfernt, und (iv) das galvanisch abgeschiedene Harz mit einem geeigneten Lösungsmittel abzieht.

Als Abdecklack kann ein nach einem Siebdruckverfahren aufgebrachtes und dann gehärtetes Epoxidharz dienen. Vorzugsweise ist der Abdecklack ein Photolack, mit dem ausgewählte Bereiche beschichtet werden, indem man ihn gleichförmig auf das Substrat, üblicherweise ein kupferkaschiertes Laminat, aufbringt, in einem vorbestimmten Muster aktinischer Strahlung aussetzt und dann belichtete bzw. unbelichtete Stellen entfernt, je nachdem ob der Photolack positiv- bzw. negativarbeitend ist. Positiv- und negativarbeitende Photolacke zur Verwendung bei der Herstellung gedruckter Schaltungen sind wohlbekannte Stoffe, die sämtlich verwendbar sind. Sie können unter wässrigen Bedingungen oder mittels eines organischen Lösungsmittels abziehbar sein. Dabei kann man eine Schicht eines anderen Metalls wie Nickel vor der galvanischen Abscheidung des Harzes auf den blanken Kupferbereichen abscheiden.

Das galvanisch abscheidbare Harz kann anodisch bzw. kathodisch abscheidbar sein und ist dementsprechend mit Base bzw. Säure abziehbar. Anodisch abscheidbare Harze werden bevorzugt, wenn saure Ätzmittel verwendet werden sollen, und kathodische Typen sind bei Verwendung alkalischer Ätzmittel für Kupfer bevorzugt.

Eine besonders bevorzugte Kombination ist die Verwendung eines unter wässrigen Bedingungen abziehbaren Photolacks und eines mittels eines organischen Lösungsmittels abziehbaren, galvanisch abscheidbaren Harzes.

Zahlreiche galvanisch abscheidbare Harze sind beliebig verwendbar; dazu gehören Acrylharze, Epoxidharz addukte mit Aminen, Polycarbonsäuren, Aminocarbonsäuren und Merkaptocarbonsäuren, Polyurethane, Polyester sowie Reaktionsprodukte hydroxylgruppenhaltiger Phenolharze mit einem Aldehyd und Amin oder Amino- oder Merkaptocarbonsäuren. Zu geeigneten Acrylharzen zählen Mischpolymere mindestens eines Acrylesters, wie eines Alkyl- oder Hydroxyalkylacrylats oder -methacrylats, mit einem äthylenisch ungesättigten, eine salzbildende Gruppe enthaltenden Monomeren, wie einem eine Carboxylgruppe oder tertiäre Aminogruppe enthaltenden Acrylmonomeren, sowie gegebenenfalls einem weiteren äthylenisch ungesättigten Monomeren. Als Epoxidharzaddukte eignen sich unter anderen solche von Diglycidyläthern zweiwertiger Alkohole oder Bisphenole mit einem stöchiometrischen Überschuss eines primären oder sekundären Monoamins oder Polyamins wie Äthanolamin, Diäthanolamin oder Äthylendiamin, einer Polycarbonsäure wie Glutarsäure oder Adipinsäure, eines Polycarbonsäureanhydrids wie Malein- oder Bernsteinsäureanhydrid, einer Aminocarbonsäure wie o-, m- oder p-Aminobenzoesäure oder einer Merkaptocarbonsäure. Zu geeigneten Polyurethanen zählen Addukte aus Polyurethanen mit Hydroxylendgruppen und Polycarbonsäureanhydriden. Zu geeigneten Polyestern gehören Polyester mit Carboxylendgruppen, welche sich von mehrwertigen Alkoholen wie Äthylenglykol, 1,2-Propylenglykol, 1,3-Propylenglykol oder Butan-1,4-diol mit Polycarbonsäuren wie Glutarsäure, Adipinsäure, Maleinsäure, Tetrahydrophthalsäure und Phthalsäure sowie deren esterbildenden Derivaten ableiten. Geeignete Reaktionsprodukte hydroxylhaltiger Phenolharze sind unter anderem solche von Diglycidylätheraddukten mit Phenolendgruppen aus Bisphenolen, Aldehyden wie Formaldehyd und Benzaldehyd und Aminen wie Äthanolamin, Diäthanolamin oder Äthylendiamin, Aminocarbonsäuren wie Glycin, Sarkosin oder Asparaginsäure oder Merkaptocarbonsäuren wie Thioglykolsäure oder 3-Merkaptopropionsäure.

Die bevorzugten galvanisch abscheidbaren Harze sind Mischpolymerisate mindestens eines Monoacrylesters, der insbesondere unter Methylacrylat, Äthylacrylat, 2-Hydroxy äthylacrylat, 2-Hydroxypropylacrylat, Butylacrylat, Äthylhexylacrylat und den entsprechenden Methacrylaten ausgewählt wird, mit mindestens einem eine Carboxylgruppe oder tertiäre Aminogruppe enthaltenden Monoacrylmonomeren, insbesondere Acrylsäure, Methacrylsäure oder Dimethylaminoäthylmethacrylat, sowie gegebenenfalls mit einem weiteren Vinylmonomeren wie Styrol. Andere bevorzugte galvanisch abscheidbare Harze sind Addukte eines gegebenenfalls vorverlängerten Diglycidyläthers eines Bisphenols, inbesondere Bisphenol A, mit einem Monoamin, insbesondere Diäthanolamin.

Die Menge abgeschiedenes Harz muss ausreichend sein, um das freigelegte Metall völlig zu bedecken und es während der Entfernung des Photolacks und während des Ätzens des so freigelegten Metalls zu schützen.

Galvanische Abscheidung über nur wenige Minuten, üblicherweise eine Minute, bei einer Spannung bis zu 200 Volt genügt in den meisten Fällen. Niedrigere Spannungen von nur 2 Volt sind manchmal verwendbar, insbesondere wenn die Grösse der Elektrode, auf der das Harz abgeschieden wird, im Verhältnis zur anderen Elektrode klein ist. Beispielsweise lässt sich ein kathodisch abscheidbares Harz bei 2 Volt oder 5 Volt Spannung auf einer kleinen Kathode in einem Tank abscheiden, wo der Tank als ganzes die Anode darstellt.

Es wurde gefunden, dass sich die Haftung des Überzugs verbessert, wenn dieser in zwei Stufen abgeschieden wird, zunächst bei niedriger Spannung und anschliessend bei etwas höherer Spannung. Ein guter Überzug ist zum Beispiel dadurch erhältlich, dass man das Harz 2 Minuten lang bei 2 Volt und anschliessend 5 Minuten lang bei 5 Volt galvanisch abscheidet.

Es ist ebenfalls möglich, eine Kombination eines Photolacks und eines galvanisch abscheidbaren Harzes einzusetzen, die beide basisch oder beide sauer abziehbar sind, sofern der Photolack unter milderen Bedingungen abziehbar ist, als zur Entfernung des galvanisch abgeschiedenen Harzes erforderlich sind, z.B. eine verdünntere Lösung einer Base oder einer Säure.

Das galvanisch abgeschiedene Harz wird vorzugsweise getrocknet, ohne es zu härten, beispielsweise durch Erhitzen auf eine Temperatur bis 100° C, bevor die Ätzstufe (iii) erfolgt, und besonders bevorzugt vor der Entfernung des Abdecklacks in der Stufe (ii).

Bei Verwendung eines organischen Lösungsmittels zur Entfernung des Abdecklacks lässt sich ein geeignetes Lösungsmittel, welches das galvanisch abgeschiedene Harz nicht auflöst, durch übliche Versuche herausfinden. Sowohl dieses Lösungsmittel als auch das zur Entfernung des galvanisch abgeschiedenen Harzes verwendete sind wahlweise Halogenkohlenwasserstoffe wie 1,1,1-Trichloräthan und Dichlormethan, hydroxylhaltige Lösungsmittel wie 2-n-Butoxyäthanol und 2-Äthoxyäthanol, Ester wie 2-Äthoxyäthylacetat, Ketone wie Aceton und Methyläthylketon sowie Äther wie Tetrahydrofuran. Leitet sich beispielsweise das galvanisch abgeschiedene Harz von einem Epoxiharz ab und ist der Abdecklack ein Acrylmaterial, so kann man den Abdecklack mit einem halogenierten Kohlenwasserstofflösungsmittel und das galvanisch abgeschiedene Harz mit einem Keton entfernen.

Das durch Entfernung des Abdecklacks freigelegte Metall, üblicherweise Kupfer, lässt sich mit jedem wohlbekannten Ätzmittel wie Ferrichlorid, Wasserstoffperoxid/Phosphorsäure, Ammoniumpersulfat oder Cuprichlorid entfernen.

Vorliegende Erfindung ist ferner zur Verwendung bei Mehrlagenleiterplatten sehr nützlich, insbesondere wenn Verbindungslöcher und Durchkontaktierungen vorliegen.

Die Erfindung wird durch die nachfolgenden Beispiele erläutert, wobei Teile Gewichtsteile sind. Die folgenden Harze werden in den Beispielen verwendet:

Harz 1

Man erhitzt Methylmethacrylat (55 Teile), Methacrylsäure (5 Teile), 2-Hydroxyäthylmethacrylat (40 Teile) und tert.Dodecylmerkaptan (0,03 Teile) in Tetrahydrofuran (THF) (350 Teile) am Rückfluss, gibt Azobis(isobutyroni tril) (1,5 Teile) dazu und hält 5 Stunden lang unter Stickstoff am Rückfluss. Das Reaktionsgemisch wird auf Raumtemperatur abgekühlt und langsam unter Rühren in Hexan (900 Teile) gegeben. Dabei bildet sich ein Niederschlag, der abfiltriert und mit weiterem Hexan gewaschen wird. Das Produkt wird bei 40°C im Vakuumtrockenschrank getrocknet, was 87 Teile eines Copolymeren mit Säurezahl 0,56 val/kg und Molekulargewicht (Zahlenmittel) 7206 ergibt.

## Harz 2

Man löst Styrol (50 Teile), Dimethylaminoäthylmethacrylat (10 Teile), Äthylhexylmethacrylat (20 Teile), 2-Hydroxypropylmethacrylat (20 Teile) und tert.Dodecylmerkaptan (0,03 Teile) in THF (340 Teile), gibt Azobis(isobutyronitril) (1,5 Teile) in THF (10 Teile) dazu und hält 5 Stunden lang unter Stickstoff am Rückfluss. Das Reaktionsgemisch wird im Vakuum abgestreift, was einen harzigen Feststoff ergibt, der anschliessend im Vakuumtrockenschrank bei 40°C getrocknet wird. Das erhaltene feste Copolymere besitzt einen Aminwert von 0,22 val/kg und ein Molekulargewicht (Zahlenmittel) von 14 538.

## Harz 3

Ein aus Styrol (26,25 Teile), Äthylhexylacrylat (10 Teile), 2-Hydroxyäthylmethacrylat (10 Teile) und Dimethylaminoäthylmethacrylat (3,75 Teile) mit Azobis(isobutyronitril) (0,75 Teile) bestehendes Monomerengemisch tropft man im Verlauf von 2 Stunden unter Rühren bei 100°C unter Stickstoff in Butoxyäthanol (25 Teile). Man hält noch 1 Stunde bei 100°C und versetzt mit einer weiteren Menge Azobis(isobutyronitril) (0,25 Teile) und Butoxyäthanol (5,0 Teile) und wiederholt diese Stufe noch zweimal. Das Reaktionsgemisch wird mit Butoxyäthanol (10 Teile) verdünnt um den Feststoffgehalt auf etwa 50% zu verringern, und zur Entfernung gegebenenfalls noch vorhandener Monomeren im Vakuum auf einem Rotationsverdampfer abgestreift. Der Aminwert der so erhaltenen Lösung beträgt 0,23 val/kg und das Molekulargewicht (Zahlenmittel) des Copolymeren 9 410.

## Harz 4

Ein aus Methylmethacrylat (46 Teile), Butylacrylat (50 Teile), Methacrylsäure (4 Teile) mit Azobis(isobutyronitril) (1,5 Teile) bestehendes Monomerengemisch tropft man im Verlauf von 2 Stunden unter Rühren bei 100°C unter Stickstoff zu Butoxyäthanol (25 Teile), hält noch 1 Stunde bei 100°C, gibt eine weitere Menge Azobis(isobutyronitril) (1,5 Teile) in Butoxyäthanol (10 Teile) dazu und wiederholt diese Stufe noch zweimal. Das Reaktionsgemisch wird mit Butoxyäthanol (20 Teile) verdünnt, um den Feststoffgehalt auf etwa 50% zu verringern, und zur Entfernung gegebenenfalls noch vorhandener Monomeren im Vakuum auf einem Rotationsverdampfer abgestreift. Die Säurezahl der so erhaltenen Lösung beträgt 0,23 val/kg und das Molekulargewicht des Copolymeren 13 276.

## Harz 5

Ein durch Vorverlängerung von Bisphenol A-diglycidyläther mittels Umsetzung mit Bisphenol A hergestelltes Epoxidharz (Epoxizahl 0,99 Mol/kg, 100 g) erhitzt man zusammen mit Butoxyäthanol (60 g) auf 140°C, wobei sich eine Lösung bildet, versetzt diese mit einer Lösung von Diäthanolamin (10,7 g) in Butoxyäthanol (13,8 g) und hält die Temperatur noch 4 Stunden bei 140°C, worauf das Reaktionsgemisch abgekühlt wird. Die dabei entstandene Lösung besitzt eine Aminzahl von 0,55 Mol/kg, und die Epoxizahl ist 0.

## Harz 6

Ein aus Styrol (47,5 Teile), Äthylhexylacrylat (25 Teile), 2-Hydroxyäthylmethacrylat (10 Teile) und Dimethylaminoäthylmethacrylat (7,5 Teile) mit Azobis(isobutyronitril) (1,5 Teile) bestehendes Monomerengemisch tropft man im Verlauf von 2 Stunden unter Rühren bei 100°C unter Stickstoff zu Butoxyäthanol (57,5 Teile), hält noch 1 Stunde bei 100°C, gibt eine weitere Menge Azobis(isobutyronitril) (0,5 Teile) und Butoxyäthanol dazu, wiederholt diese Stufe noch zweimal, hält noch 1 Stunde bei 100°C und kühlt dann ab. Die Aminzahl der so entstandenen Lösung beträgt 0,28 val/kg und das Molekulargewicht des Copolymeren 10 416.

## Harz 7

Ein aus Styrol (40 Teile), Äthylhexylacrylat (32,5 Teile), 2-Hydroxyäthylmethacrylat (20 Teile) und Dimethylaminoäthylmethacrylat (7,5 Teile) mit Azobis(isobutyronitril) (1,5 Teile) bestehendes Monomerengemisch tropft man im Verlauf von 2 Stunden unter Rühren bei 100°C unter Stickstoff zu Butoxyäthanol (57,5 Teile), hält noch 1 Stunde bei 100°C, gibt eine weitere Menge Azobis(isobutyronitril) (0,5 Teile) und Butoxyäthanol dazu, wiederholt diese Stufe noch zweimal, hält noch 1 Stunde bei 100°C und kühlt dann ab. Die Aminzahl der so entstandenen Lösung beträgt 0,28 val/kg und das Molekulargewicht des Copolymeren 10 307.

## Harz 8

Ein aus Styrol (55 Teile), Äthylhexylacrylat (20 Teile), 2-Hydroxyäthylmethacrylat (20 Teile) und Dimethylaminoäthylmethacrylat (5 Teile) mit Azobis(isobutyronitril) (1,5 Teile) bestehendes Monomerengemisch tropft man im Verlauf von 2 Stunden unter Rühren bei 100°C unter Stickstoff zu Butoxyäthanol (50 Teile), hält noch 1 Stunde bei 100°C, gibt eine weitere Menge Azobis(isobutyronitril) (0,5 Teile) in Butoxyäthanol (10 Teile) dazu und wiederholt diese Stufe noch zweimal. Das Reaktionsgemisch wird mit Butoxyäthanol (20 Teile) verdünnt, um den Feststoffgehalt auf etwa 50% zu verringern, und zur Entfernung gegebenenfalls noch vorhandener Monomeren im Vakuum auf einem Rotationsverdampfer abgestreift. Die Aminzahl der so entstandenen Lösung beträgt 0,15 val/kg.

## Harz 9

Ein aus Styrol (35 Teile), Butylacrylat (35 Teile), 2-Hydroxyäthylmethacrylat (15 Teile) und Dimethylaminoäthylmethacrylat (15 Teile) mit Azobis(isobutyronitril) (1,5 Teile) bestehendes Monomerengemisch tropft man im Verlauf von 2 Stunden unter Rühren bei 100°C unter Stickstoff zu Butoxyäthanol (50 Teile), hält noch 1 Stunde bei 100°C, gibt eine weitere Menge Azobis(isobutyronitril) (0.5 Teile) in Butoxyäthanol (10 Teile) dazu und wiederholt diese Stufe noch zweimal. Das Reaktionsgemisch wird mit Butoxyäthanol (20 Teile) verdünnt, um den Feststoffgehalt auf etwa 50% zu verringern, und zur Entfernung gegebenenfalls noch vorhandener Monomeren im Vakuum auf einem Rotationsverdampfer abgestreift. Die Aminzahl der so entstandenen Lösung beträgt 0,45 val/kg.

Harz 10

Ein aus Methylmethacrylat (66 Teile), Butylacrylat (26,2 Teile) und Dimethylaminoäthylmethacrylat (7,8 Teile) mit Azobis(isobutyronitril) (1.0 Teile) bestehendes Monomerengemisch tropft man im Verlauf von dreieinhalb Stunden bei 105°C zu Butoxyäthanol (60 Teile), hält noch 1 Stunde bei 100°C und gibt eine weitere Menge Azobis(isobutyronitril) (0,1 Teile) in Butoxyäthanol (4 Teile) dazu. Nach noch 1 Stunde bei 105°C wird das Gemisch zur Entfernung gegebenenfalls noch vorhandener Monomeren im Vakuum auf einem Rotationsverdampfer abgestreift. Die Aminzahl der so entstandenen Lösung beträgt 0,30 val/kg.

Harz 11

Ein aus Styrol (15 Teile), Methylmethacrylat (27,5 Teile), Äthylhexylacrylat (30 Teile), 2-Hydroxyäthylmethacrylat (20 Teile) und Dimethylaminoäthylmethacrylat (7,5 Teile) mit Azobis(isobutyronitril) (1,5 Teile) bestehendes Monomerengemisch tropft man im Verlauf von 2 Stunden bei 100°C zu Butoxyäthanol (50 Teile), hält noch 1 Stunde bei 100°C und gibt eine weitere Menge Azobis(isobutyronitril) (0.5 Teile) in Butoxyäthanol (5,5 Teile) dazu. Nach noch 1 Stunde bei 100°C wird das Gemisch abgekühlt. Die Aminzahl der so entstandenen Lösung beträgt 0,28 val/kg und das Molekulargewicht des Copolymeren 10 348.

Beispiel 1:

Eine wässrig entwickelbare negativ-arbeitende Photolackzusammensetzung stellt man aus
Triäthylenglykoldimethacrylat     20 Teile
Benzophenon     4 Teile
Michlers Keton     1 Teil
Styrol/Butylmaleinatcopolymer     75    Teile    (von Monsanto als Scripset 540 erhältlich)
Methyläthylketon     200 Teile
her.

Mit dieser beschichtet man ein kupferkaschiertes Laminat unter Verwendung einer Spiralrakel und trocknet 5 Minuten lang bei 90°C zu einem 8 Mikron dicken Film. Dieser wird 30 Sekunden lang mit einer Mitteldruckquecksilberhalogenidlampe von 5 000 W im Abstand von 75 cm durch ein bildtragendes Transparent hindurch bestrahlt. Beim Eintauchen in 0,5%ige wässrige Natronlauge bei 25°C wird der Photolack von den unbestrahlten Stellen entfernt, so dass dort das Kupfer freigelegt wird und ein klares Negativbild des Transparents entsteht.

Das bildtragende kupferkaschierte Laminat wird dann als Anode in ein galvanisches Abscheidungsbad eingetaucht, das mit einer Edelstahlkathode versehen ist und die folgende Lösung enthält:
Harz 1     50 Teile
Butoxyäthanol     50 Teile
Kalilauge (20% wässrig)     7.9 Teile
Wasser     392.1 Teile

Man legt 60 Sekunden lang 50 Volt Spannung an, entnimmt das kupferkaschierte Laminat aus dem Bad, spült mit Wasser und trocknet 5 Minuten lang bei 90°C. Das galvanisch abgeschiedene Harz füllt die Stellen, wo Kupfer freiliegt. Das Laminat wird dann unter Rühren in ein Bad aus 1,5%iger wässriger Natronlauge bei 25°C eingetaucht. Diese Behandlung entfernt den Photolack, und das galvanisch abgeschiedene Harz bleibt zurück.

Das freigelegte Kupfer wird durch Eintauchen in 40%ige wässrige Ferrichloridlösung bei 30°C weggeätzt, wonach man die Platte mit Wasser wäscht und trocknet. Durch 5 Minuten langes Eintauchen in 5%ige wässrige Natronlauge wird restliches Harz vollständig entfernt, wobei ein klares Leiterbild aus Kupfer auf dem Laminatträger verbleibt.

Beispiel 2:

Ein kupferkaschiertes, mit einem wässrig entwickelbaren, negativ-arbeitenden RISTON-Photolack beschichtetes Laminat, das bebildert und unter Bildung eines Leiterbilds im RISTON-Photolack entwickelt wurde, wird als Kathode in einem mit einer Edelstahlanode versehenen galvanischen Abscheidungsbad verwendet. Dieses enthält die folgende Lösung:
Harz 2     40 Teile
Butoxyäthanol     30 Teile
Milchsäure (15% wässrig)     13 Teile
Wasser     317 Teile

Man legt 60 Sekunden lang 40 Volt Spannung an, entnimmt das kupferkaschierte Laminat aus dem Bad, spült mit Wasser und trocknet 5 Minuten lang bei 90°C. Das galvanisch abgeschiedene Harz füllt die Stellen, wo Kupfer freiliegt. Das Laminat wird dann unter Rühren in ein Bad aus 3%iger wässriger Kalilauge bei 40°C eingetaucht. Diese Behandlung entfernt den Photolack, und das galvanisch abgeschiedene Harz bleibt zurück.

Das freigelegte Kupfer wird durch Eintauchen in 40%ige wässrige Ferrichloridlösung bei 30°C weggeätzt, wonach man die Platte mit Wasser wäscht und trocknet. Restliches Harz wird durch Eintauchen in ein Acetonbad vollständig entfernt, wobei ein klares Leiterbild aus Kupfer auf dem Laminatträger verbleibt.

Beispiel 3:

Ein kupferkaschiertes, mit einem wässrig entwickelbaren, negativ-arbeitenden RISTON-Photolack beschichtetes Laminat, das bebildert und unter Bildung eines Leiterbilds im RISTON-Photolack entwickelt wurde, wird als Kathode in einem mit einer Edelstahlanode versehenen galvanischen Abscheidungsbad verwendet. Dieses enthält die folgende Lösung:
Harz 3     100 Teile
Milchsäure (20% wässrig)     6,6 Teile
Wasser     393,4 Teile

Man legt 60 Sekunden lang 50 Volt Spannung an, entnimmt das kupferkaschierte Laminat aus dem Bad, spült mit Wasser und trocknet 5 Minuten lang bei 90°C. Das galvanisch abgeschiedene Harz füllt die Stellen, wo Kupfer freiliegt. Das Laminat wird dann unter Rühren in ein Bad aus 3%iger wässriger Kalilauge bei 40°C eingetaucht Diese Behandlung entfernt den Photolack, und das galvanisch abgeschiedene Harz bleibt zurück.

Das freigelegte Kupfer wird durch Eintauchen in ein Ammoniumpersulfat (125 g) und Phosphorsäure (75% - 25 cm³) enthaltendes und mit Wasser auf 500 cm³ aufgefülltes Ätzbad bei 40°C weggeätzt. Nach Spülen in Wasser und Trocknen wird restliches Harz durch Eintauchen in ein Acetonbad vollständig entfernt, wobei ein klares Leiterbild aus Kupfer auf dem Laminatträger verbleibt.

Beispiel 4:

Gemäss der Arbeitsweise nach Beispiel 3 verwendet man ein RISTON-beschichtetes Laminat, um eine Abbildung des Originalphotolacks in galvanisch abgeschiedenem Harz 3 zu erhalten. Das freigelegte Kupfer wird durch Eintauchen in ein Wasserstoffperoxid (30% - 200 g), Phosphorsäure (75% - 200 g) und Kaliumpermanganat (0,006 g) enthaltendes und mit Wasser auf 1 Liter aufgefülltes Bad bei 70°C weggeätzt. Nach Spülen in Wasser und Trocknen wird restliches Harz durch Eintauchen in ein Acetonbad vollständig entfernt, wobei ein klares Leiterbild aus Kupfer auf dem Laminatträger verbleibt.

Beispiel 5:

Gemäss der Arbeitsweise nach Beispiel 3 verwendet man ein RISTON-beschichtetes Laminat, um eine Abbildung des Originalphotolacks in galvanisch abgeschiedenem Harz 3 zu erhalten. Das freigelegte Kupfer wird durch Eintauchen in ein Ammoniumchlorid (21,4 g), Ammoniak (25% - 12g), Wasserstoffperoxid (30% - 12 cm³) und Wasser (150 g) enthaltendes Bad bei 25°C weggeätzt. Nach Spülen in Wasser und Trocknen wird restliches Harz durch Eintauchen in ein Acetonbad vollständig entfernt, wobei ein klares Leiterbild aus Kupfer auf dem Laminatträger verbleibt.

Beispiel 6:

Ein kupferkaschiertes, mit einem wässrig entwikkelbaren, negativ-arbeitenden RISTON-Photolack beschichtetes Laminat, das bebildert und unter Bildung eines Leiterbilds im RISTON-Photolack entwickelt wurde, wird als Anode in einem mit einer Edelstahlkathode versehenen galvanischen Abscheidungsbad verwendet. Dieses enthält die folgende Lösung:
Harz 4          100 Teile
Kalilauge (20% wässrig)          5.2 Teile
Wasser          394,8 Teile
Man legt 60 Sekunden lang 80 Volt Spannung an, entnimmt das kupferkaschierte Laminat aus dem Bad, spült mit Wasser und trocknet 5 Minuten lang bei 90°C. Das galvanisch abgeschiedene Harz füllt die Stellen, wo Kupfer freiliegt. Das Laminat wird dann unter Rühren in ein Bad aus 3%iger wässriger Kalilauge bei 40°C eingetaucht. Diese Behandlung entfernt den Photolack, und das galvanisch abgeschiedene Harz bleibt zurück.

Das freigelegte Kupfer wird durch Eintauchen in 40%ige wässrige Ferrichloridlösung bei 30°C weggeätzt, wonach man die Platte mit Wasser wäscht und trocknet. Restliches Harz wird durch Eintauchen in ein Acetonbad vollständig enfernt, wobei ein klaresLeiterbild aus Kupfer auf dem Laminatträger verbleibt.

Beispiel 7:

Ein kupferkaschiertes, mit einem negativ-arbeitenden RISTON-Photolack beschichtetes Laminat, das bebildert und unter Bildung eines Leiterbilds im RISTON-Photolack entwickelt wurde, wird als Kathode in einem mit einer Edelstahlanode versehenen galvanischen Abscheidungsbad verwendet. Dieses enthält die folgende Lösung:
Harz 5          60 Teile
Butoxyäthanol          50 Teile
Milchsäure (20% wässrig)          15,8 Teile
Wasser          474,2 Teile
Man legt 60 Sekunden lang 30 Volt Spannung an, entnimmt das Kupferlaminat aus dem Bad, spült mit Wasser und trocknet 5 Minuten lang bei 90°C. Das galvanisch abgeschiedene Harz füllt die Stellen, wo Kupfer freiliegt. Das Laminat wird dann unter Rühren in ein Bad eingetaucht, das ein Lösungsmittelgemisch aus 1,1,1-Trichloräthan und Dichlormethan (80:20) enthält. Diese Behandlung entfernt den Photolack, und das galvanisch abgeschiedene Harz bleibt zurück.

Das freigelegte Kupfer wird durch Eintauchen in 40%ige wässrige Ferrichloridlösung bei 30°C weggeätzt, wonach man die Platte mit Wasser wäscht und trocknet. Restliches Harz wird durch Eintauchen in ein Acetonbad vollständig entfernt, wobei ein klares Leiterbild aus Kupfer auf dem Laminat verbleibt.

Beispiel 8:

Eine positiv-arbeitende Photolackzusammensetzung wird durch Vermischen des Reaktionsprodukts aus 1,2-Naphthochinon-2-diazid-5-sulfonylchlorid und 2,3,4-Trihydroxybenzophenon (Veresterungsgrad 2,5 Mol) mit einem p-tert.-Butylphenol/Phenolnovolak (Molverhältnis 0,25:0,75), so dass das Verhältnis von Novolak zu Sensibilisator 5:1 beträgt, hergestellt. Das Gemisch wird in einem Lösungsmittelgemisch aus 2-Äthoxyäthanol, 2-Äthoxyäthanolacetat und Methyläthylketon (Volumenverhältnis 2:2:1) zu einer Lösung von 40 Gew.-% Feststoffgehalt gelöst. Die Lösung bringt man mit einer Spiralrakel auf ein kupferkaschiertes Laminat auf und trocknet 5 Minuten lang bei 90°C zu einem 30 Mikron dicken Harzfilm. Dann bestrahlt man 30 Sekunden lang unter einer Mitteldruckquecksilberhalogenidlampe von 5 000 W im Abstand von 75 cm durch ein bildtragendes Transparent hindurch. Das Laminat wird 1 Minute lang in ein 0,5%ige wässrige Natronlauge enthaltendes Bad eingetaucht, wonach sich eine positive Abbildung entwickelt.

Das bildtragende kupferkaschierte Laminat wird dann als Kathode in ein mit einer Edelstahlanode versehenes und die folgende Lösung enthaltendes galvanisches Abscheidungsbad eingetaucht:

Harz 3    100 Teile
Milchsäure (20% wässrig)    6,6 Teile
Wasser    393,4 Teile

Man legt 60 Sekunden lang 50 Volt Spannung an, entnimmt das kupferkaschierte Laminat aus dem Bad, spült mit Wasser und trocknet 5 Minuten lang bei 90°C. Das galvanisch abgeschiedene Harz füllt die Stellen, wo Kupfer freiliegt. Das Laminat wird dann unter Rühren in ein Bad aus 3%iger wässriger Kalilauge bei 40°C eingetaucht. Diese Behandlung entfernt den Photolack, und das galvanisch abgeschiedene Harz bleibt zurück.

Das freigelegte Kupfer wird durch Eintauchen in ein 40%iges wässriges Ferrichlorid enthaltendes Ätzbad bei 30°C weggeätzt, wonach man die Platte mit Wasser wäscht und trocknet. Restliches Harz wird durch Eintauchen in ein Acetonbad vollständig entfernt, wobei ein klares Leiterbild aus Kupfer auf dem Laminatträger verbleibt.

Beispiel 9:

Ein kupferkaschiertes, mit einem wässrig entwickelbaren, negativ-arbeitenden RISTON-Photolack beschichtetes Laminat, das bebildert und unter Bildung eines Leiterbilds im RISTON-Photolack entwickelt wurde, wird als Kathode in einem mit einer Edelstahlanode versehenen galvanischen Abscheidungsbad verwendet. Dieses enthält die folgende Lösung:

Harz 3    100 Teile
Milchsäure (20%ig)    6,6 Teile
Wasser    393,4 Teile

Man legt 50 Sekunden lang 50 Volt Spannung an, entnimmt das kupferkaschierte Laminat aus dem Bad und spült mit Wasser. Das galvanisch abgeschiedene Harz füllt die Stellen, wo Kupfer freiliegt. Das Laminat wird dann unter Rühren in ein Bad aus 3%iger wässriger Kalilauge bei 40°C eingetaucht. Diese Behandlung entfernt den Photolack, und das galvanisch abgeschiedene Harz bleibt zurück. Das freigelegte Kupfer wird durch Eintauchen in 40%ige wässrige Ferrichloridlösung bei 30°C weggeätzt, wonach man die Platte mit Wasser wäscht. Restliches Harz wird durch Eintauchen in ein Acetonbad vollständig entfernt, wobei ein klares Leiterbild aus Kupfer auf dem Laminatträger verbleibt.

Beispiel 10:

Ein kupferkaschiertes Laminat mit einem wässrig entwickelbaren, negativ-arbeitenden RISTON-Photolack, das bebildert und unter Bildung eines Leiterbilds im RISTON-Photolack entwickelt wurde, wird als Kathode in einem mit einer Edelstahlanode versehenen galvanischen Abscheidungsbad verwendet. Dieses enthält die folgende Lösung:

Harz 3    100 Teile
Milchsäure (20%ig)    6,6 Teile
Wasser    393,4 Teile

Man legt 60 Sekunden lang 50 Volt Spannung an, entnimmt das kupferkaschierte Laminat aus dem Bad und spült mit Wasser. Das galvanisch abgeschiedene Harz füllt die Stellen, wo Kupfer freiliegt. Das Laminat wird dann unter Rühren in ein Bad aus 3%iger wässriger Kalilauge bei 40°C eingetaucht. Diese Behandlung entfernt den Photolack, und das galvanisch abgeschiedene Harz bleibt zurück. Das frei gelegte Kupfer wird durch Eintauchen in 40%ige wässrige Ferrichloridlösung bei 30°C weggeätzt, wonach man die Platte mit Wasser wäscht. Restliches Harz wird durch Eintauchen in ein Acetonbad vollständig entfernt, wobei ein klares Leiterbild aus Kupfer auf dem Laminatträger ver bleibt.

Beispiel 11:

Ein kupferkaschiertes Laminat mit einem wässrig entwickelbaren, negativ-arbeitenden RISTON-Photolack, das bebildert und unter Bildung eines Leiterbilds im RISTON-Photolack entwickelt wurde, wird als Kathode in einem mit einer Edelstahlanode versehenen galvanischen Abscheidungsbad verwendet. Dieses enthält die folgende Lösung:

Harz 6    100 Teile
Milchsäure (20% wässrig)    16,8 Teile
Wasser    483,2 Teile

Man legt 60 Sekunden lang 50 Volt Spannung an, entnimmt das kupferkaschierte Laminat aus dem Bad, spült mit Wasser und trocknet 5 Minuten lang bei 90°C. Das galvanisch abgeschiedene Harz füllt die Stellen, wo Kupfer freiliegt. Das Laminat wird dann unter Rühren in ein Bad aus 3%iger wässriger Kalilauge bei 40°C eingetaucht. Diese Behandlung entfernt den Photolack, und der galvanisch abgeschiedene Film bleibt zurück. Das freigelegte Kupfer wird durch Eintauchen in ein 40%iges wässriges Ferrichlorid enthaltendes Ätzbad bei 30°C weggeätzt, wonach man die Platte mit Wasser wäscht und trocknet. Restliches Harz wird durch Eintauchen in ein Acetonbad vollständig entfernt, wobei ein klares Leiterbild aus Kupfer auf dem Laminatträger verbleibt.

Beispiel 12:

Man wiederholt Beispiel 11 mit dem Unterschied, dass die 60 Sekunden lang angelegte Spannung 20 Volt beträgt. Dabei erhält man ebenfalls ein klares Leiterbild aus Kupfer auf dem Laminatträger.

Beispiel 13:

Man wiederholt Beispiel 11 mit dem Unterschied, dass die 60 Sekunden lang angelegte Spannung 120 Volt beträgt. Dabei erhält man ebenfalls ein klares Leiterbild aus Kupfer auf dem Laminatträger.

Beispiel 14:

Man wiederholt Beispiel 11 mit dem Unterschied, dass man ein zweiseitig kupferkaschiertes Laminat mit Durchgangsbohrungen mit einem wässrig entwickelbaren, negativ-arbeitenden RISTON-Photolack verwendet, das beidseitig bebildert und entwickelt wurde. Dabei erhält man ein klares Leiterbild aus Kupfer auf beiden Seiten des Laminatträgers und in den Durchgangsbohrungen.

Beispiel 15:

Ein kupferkaschiertes Laminat mit einem wässrig entwickelbaren, negativ-arbeitenden RISTON-Photolack, das bebildert und unter Bildung eines Leiterbilds im RISTON-Photolack entwickelt wurde, wird als Kathode in einem mit einer Edelstahlanode versehenen galvanischen Abscheidungsbad verwendet. Dieses enthält die folgende Lösung:

Harz 7     100 Teile
Milchsäure (20% wässrig)     16,8 Teile
Wasser     483,2 Teile

Man legt 60 Sekunden lang 50 Volt Spannung an, entnimmt das kupferkaschierte Laminat aus dem Bad, spült mit Wasser und trocknet 5 Minuten lang bei 90°C. Das galvanisch abgeschiedene Harz füllt die Stellen, wo Kupfer freiliegt. Das Laminat wird dann unter Rühren in ein Bad aus 35%iger wässriger Kalilauge bei 40°C eingetaucht. Diese Behandlung entfernt den Photolack, und der galvanisch abgeschiedene Film bleibt zurück. Das freigelegte Kupfer wird durch Eintauchen in ein 40%iges wässriges Ferrichlorid enthaltendes Ätzbad bei 30°C weggeätzt, wonach man die Platte in Wasser wäscht und trocknet. Restliches Harz wird durch Eintauchen in ein Acetonbad vollständig entfernt, wobei ein klares Leiterbild aus Kupfer auf dem Laminatträger verbleibt.

### Beispiel 16:

Man wiederholt Beispiel 15 mit dem Unterschied, dass das galvanische Abscheidungsbad die folgende Lösung enthält:

Harz 8     100 Teile
Milchsäure (20% wässrig)     6,6 Teile
Wasser     393,4 Teile

und 30 Volt Spannung 60 Sekunden lang angelegt wird. Dabei erhält man ein klares Leiterbild aus Kupfer auf dem Laminatträger.

### Beispiel 17:

Man wiederholt Beispiel 15 mit dem Unterschied, dass das galvanische Abscheidungsbad die folgende Lösung enthält:

Harz 9     100 Teile
Milchsäure (20% wässrig)     13,8 Teile
Wasser     386,2 Teile

und 40 Volt Spannung 60 Sekunden lang angelegt wird. Dabei erhält man ein klares Leiterbild aus Kupfer auf dem Laminatträger.

### Beispiel 18:

Man wiederholt Beispiel 15 mit dem Unterschied, dass das galvanische Abscheidungsbad die folgende Lösung enthält:

Harz 10     100 Teile
Milchsäure (20% wässrig)     9 Teile
Wasser     391 Teile

Dabei erhält man ein klares Leiterbild aus Kupfer auf dem Laminatträger.

### Beispiel 19:

Man wiederholt Beispiel 15 mit dem Unterschied, dass das galvanische Abscheidungsbad die folgende Lösung enthält:

Harz 11     100 Teile
Milchsäure (20% wässrig)     6,7 Teile
Wasser     493,3 Teile

Dabei erhält man ein klares Leiterbild aus Kupfer auf dem Laminatträger.

### Beispiel 20:

Ein kupferkaschiertes Laminat mit einem wässrig entwickelbaren, negativ-arbeitenden RISTON-Photolack, das bebildert und unter Bildung eines Leiterbilds im RISTON-Photolack entwickelt wurde, wird als Kathode in einem mit einer Edelstahlanode versehenen galvanischen Abscheidungsbad verwendet. Dieses enthält die folgende Lösung:

Harz 6     100 Teile
Milchsäure (20% wässrig)     16,8 Teile
Wasser     383,2 Teile

Man legt 2 Minuten lang 2 Volt Spannung und danach 4 Minuten lang 5 Volt Spannung an. Das Laminat wird dem Bad entnommen, mit Wasser gespült und 5 Minuten lang bei 90°C getrocknet. Das galvanisch abgeschiedene Harz füllt die Stellen, wo Kupfer freiliegt. Das Laminat wird dann unter Rühren in ein Bad aus 3%iger wässriger Kalilauge bei 40°C eingetaucht. Diese Behandlung entfernt den Photolack, und der galvanisch abgeschiedene Film bleibt zurück. Das freigelegte Kupfer wird durch Eintauchen in ein 40%iges wässriges Ferrichlorid enthaltendes Ätzbad bei 30°C weggeätzt, wonach man die Platte mit Wasser wäscht und trocknet. Restliches Harz wird durch Eintauchen in ein Acetonbad vollständig entfernt, wobei ein klares Leiterbild aus Kupfer auf dem Laminatträger verbleibt.

### Patentansprüche

1. Verfahren zur Herstellung metallischer Strukturen auf einem Substrat mit einer in vorbestimmten Bereichen aus blankem Metall und in den übrigen Bereichen aus mit einem Abdecklack beschichteten Metall bestehenden Oberfläche, dadurch gekennzeichnet, dass man (i) das blanke Metall durch galvanische Abscheidung eines Harzes darauf schützt, (ii) unter Belassung des galvanisch abgeschiedenen Harzes in weitgehend ungehärtetem Zustand den Abdecklack ausjenen übrigen Bereichen mittels eines Lösungsmittels abzieht, welches das galvanisch abgeschiedene Harz nicht entfernt, wodurch das Metall in diesen übrigen Bereichen freigelegt wird, (iii) das in (ii) freigelegte Metall mittels eines Ätzmittels ätzt, welches das galvanisch abgeschiedene Harz nicht entfernt, und (iv) das galvanisch abgeschiedene Harz mit einem geeigneten Lösungsmittel abzieht.

2. Verfahren nach Anspruch 1, dadurch gekennzeichnet, dass der Abdecklack ein unter wässrigen Bedingungen oder mittels eines organischen Lösungsmittels abziehbarer Photolack ist.

3. Verfahren nach Anspruch 1, dadurch gekennzeichnet, dass der Photolack unter wässrigen Bedingungen und das galvanisch abgeschiedene Harz mittels eines organischen Lösungsmittels abziehbar ist.

4. Verfahren nach Anspruch 1, dadurch gekennzeichnet, dass als galvanisch abscheidbares Harz ein Acrylharz, ein Epoxidharzaddukt mit einem Amin, einer Polycarbonsäure bzw. deren Anhydrid, einer Aminocarbonsäure oder Merkaptocarbonsäure, ein Polyurethan, ein Polyester oder ein Reaktionsprodukt eines hydroxylgruppenhaltigen Phenolharzes mit einem Aldehyd und einem Amin oder einer Amino- oder Merkaptocarbonsäure vorliegt.

5. Verfahren nach Anspruch 4, dadurch gekennzeichnet, dass als galvanisch abgeschiedenes Harz ein Mischpolymerisat mindestens eines Monoacrylesters mit mindestens einem eine Carboxylgruppe oder tertiäre Aminogruppe enthaltenden Monoacrylmonomeren sowie gegebenenfalls einem weiteren Vinylmonomeren vorliegt.

6. Verfahren nach Anspruch 4, dadurch gekennzeichnet, dass als galvanisch abgescchiedenes Harz ein Addukt eines gegebenenfalls vorverlängerten Diglycidyläthers eines Bisphenols mit einem Monoamin vorliegt.

7. Verfahren nach Anspruch 1, dadurch gekennzeichnet, dass die galvanische Abscheidung bei einer Spannung von 2 bis 200 Volt erfolgt.

8. Verfahren nach Anspruch 7, dadurch gekennzeichnet, dass die galvanische Abscheidung in zwei Stufen erfolgt, zunächst bei niedriger Spannung und anschliessend bei etwas höherer Spannung.

9. Verfahren nach Anspruch 1, dadurch gekennzeichnet, dass das galvanisch abgeschiedene Harz vor der Ätzstufe (iii) ohne Härtung getrocknet wird.

10. Verfahren nach Anspruch 9, dadurch gekennzeichnet, dass das galvanisch abgeschiedene Harz vor der Entfernung des Abdecklacks in Stufe (ii) getrocknet wird.

11. Verfahren nach Anspruch 1, dadurch gekennzeichnet, dass als metallische Struktur eine gedruckte Schaltung und als als Metall Kupfer vorliegt.

12. Verfahren nach Anspruch 11, dadurch gekennzeichnet, dass als gedruckte Schaltung eine durchkontaktierte Leiterplatte vorliegt.